# FASCICULE DE BREVET EUROPEEN

(11) **EP 2 157 608 B1**
(45) Date de publication et mention de la délivrance du brevet: **06.07.2011**
(21) Numéro de dépôt: 09167014.1
(22) Date de dépôt: 31.07.2009
(51) Int. Cl.: H01L 27/10, G11C 17/16

(54) **Stockage d'une image dans un circuit intégré**
Speicherung eines Bildes in einem integrierten Schaltkreis
Storage of an image in an integrated circuit

(30) Priorité: 19.08.2008 FR 0855628
(43) Date de publication de la demande: 24.02.2010
(73) Titulaire: STMicroelectronics (Rousset) SAS, 13790 Rousset (FR)
(72) Inventeur: Fornara, Pascal, 83910, Pourrieres (FR); Marinet, Fabrice, 13790, Chateauneuf le Rouge (FR)
(74) Mandataire: de Beaumont, Michel

(56) Documents cités:
- US-A1- 2006 203 591
- LI Y G ET AL: "Test structure failed node localization and analysis from die backside" PHYSICAL AND FAILURE ANALYSIS OF INTEGRATED CIRCUITS, 2008. IPFA 2008. 15TH INTERNATIONAL SYMPOSIUM ON THE, IEEE, PISCATAWAY, NJ, USA, 7 juillet 2008 (2008-07-07), pages 1-3, XP031297711 ISBN: 978-1-4244-2039-1
- ZHIGANG SONG ET AL: "Open contact analysis of single bit failure in 0.18 [mu]m technology" MICROELECTRONICS RELIABILITY ELSEVIER UK, vol. 42, no. 12, décembre 2002 (2002-12), pages 1997-2001, XP002520276 ISSN: 0026-2714
- SONG Z G ET AL: "Application of contact-level ion-beam induced passive voltage contrast in failure analysis of static random access memory" 2001, PROCEEDINGS OF THE INTERNATIONAL SYMPOSIUM ON THE PHYSICAL AND FAILURE ANALYSIS OF INTEGRATED CIRCUITS, IPFA 2001 INSTITUTE OF ELECTRICAL AND ELECTRONICS ENGINEERS INC. US, PAGE(S) 103 - 106 , XP002520277 * le document en entier *
- SONG Z G ET AL: "Front-end processing defect localization by contact-level passive voltage contrast technique and root cause analysis" PHYSICAL AND FAILURE ANALYSIS OF INTEGRATED CIRCUITS, 2002. IPFA 2002. PROCEEDINGS OF THE 9TH INTERNATIONAL SYMPOSIUM ON THE 8-12 JULY 2002, PISCATAWAY, NJ, USA,IEEE, 8 juillet 2002 (2002-07-08), pages 97-100, XP010597768 ISBN: 978-0-7803-7416-4

## Description

### Domaine de l'invention

La présente invention concerne de façon générale les circuits intégrés et, plus particulièrement, le stockage de façon non volatile dans un circuit intégré d'une image lors de la fabrication du circuit.

### Exposé de l'art antérieur

Dans de nombreux cas, on a besoin de stocker de façon définitive une image dans un circuit intégré lors de la fabrication du circuit intégré. L'image représente, par exemple, un identifiant de la plaquette (wafer) au niveau de laquelle est fabriqué le circuit intégré, la position du circuit intégré sur la plaquette, un identifiant du lot de plaquettes auquel appartient la plaquette du circuit intégré, etc.

De façon générale, pour stocker définitivement une image sous la forme de données binaires dans un circuit intégré, on utilise généralement une mémoire de type ROM, une mémoire non volatile effaçable et programmable électriquement (ou mémoire EEPROM, de l'anglais Electrically Erasable Programmable Read Only Memory), etc.

Un inconvénient est que l'image à stocker peut ne pas être disponible au moment où sont définis les masques de gravure utilisés au cours de la fabrication du circuit intégré. De plus, l'image à stocker peut varier d'une plaquette à l'autre, notamment lorsqu'elle représente des identifiants de plaquette et de lot de plaquettes. Le stockage de données dans une mémoire ROM nécessitant de façon générale l'utilisation d'au moins un masque spécifique pour la formation des connexions des cellules mémoire, il n'est pas compatible, pour une fabrication de circuits à une échelle industrielle, de devoir multiplier le nombre de masques à utiliser.

En outre, il est souhaitable que l'image stockée reste accessible même lorsque le circuit intégré est hors service. A titre d'exemple, lorsque l'image stockée représente l'identifiant du lot, l'identifiant de la plaquette, la position du circuit intégré, etc., c'est généralement lors d'un mauvais fonctionnement du circuit intégré que l'on souhaite accéder à cette image pour faciliter la détermination des causes du mauvais fonctionnement. Lorsque l'image est stockée dans une mémoire ROM, une mémoire EEPROM, etc., il n'est plus possible de la lire lorsque le circuit n'est plus fonctionnel.

Un exemple de procédé de stockage de façon définitive d'une image au niveau d'un circuit intégré, permettant que l'image stockée reste accessible lorsque le circuit intégré est hors service et permettant facilement de stocker des images différentes d'un circuit intégré à l'autre, consiste à balayer la surface supérieure du circuit intégré avec un laser de façon à graver l'image sous forme de motifs sur une partie du circuit intégré. Toutefois, un tel procédé doit être mis en oeuvre séparément sur chaque circuit intégré et n'est donc pas compatible avec la fabrication de circuits intégrés à une échelle industrielle. En outre, les images à stocker peuvent ne pas être disponibles au moment où le procédé de gravure par laser doit être mis en oeuvre.

US2006203591 (fig. 1-3H ; §2-20) dévoile un OTPROM comprenant des premiers plots (15) d'un premier niveau de métallisation connectés au substrat (§5: "destroyed fuse") et des seconds plots (15) séparés du substrat (§5: "undestroyed fuse") par une portion isolante (10). Les plots ne sont en revanche pas reliés à un élément de sélection par l'intermédiaire d'un élément de couplage capacitif.

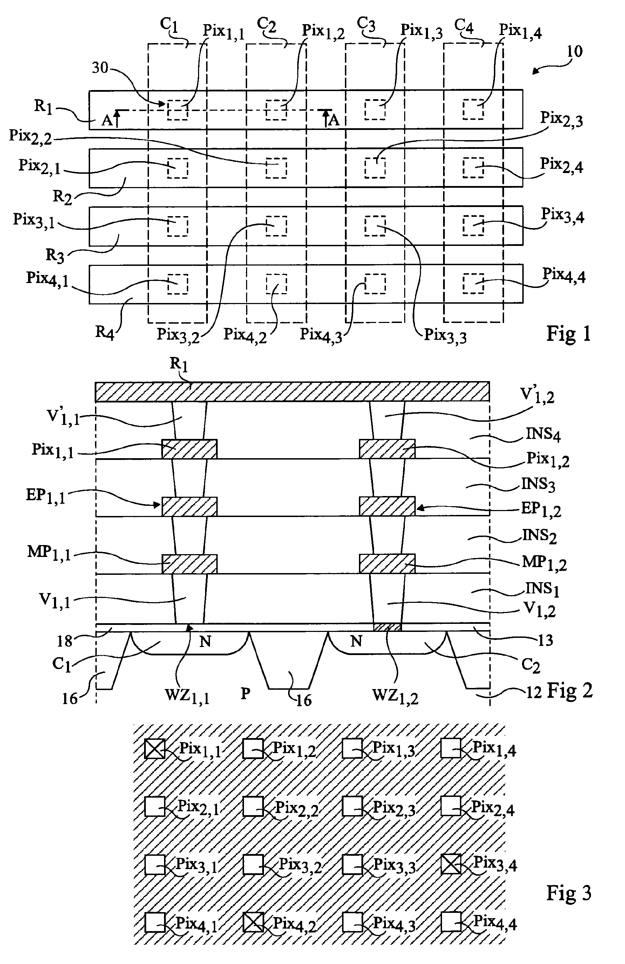

D'autre part, différents procédés d'imagerie par contraste de potentiels sont connus, par exemple les procédés PVC ou C-AFM. Les documents suivants: "Test structure failed node localization and analysis from die backside de Li et al (Physical and failure analysis on integrated circuits, 2008. IPFA 2008), "Open contact analysis of single bit failure in 0,18 µm technology" de Song et al (Microelectronics reliability Elsevier UK, vol. 42, n° 12, décembre 2002, p. 1997-2001) et "Application of contact-level ion-beam induced passive voltage contrast in failure analysis of static random access memory" de Song et al (Proceedings of the international symposium on the physical and failure analysis of integrated circuits, IPFA 2001, p. 103-106) dévoilent des méthodes de localisation de défauts dans les chaînes de contacts ("open contact") par contraste de potentiels (contact-level PVC). Il s'agit dans chacun des documents cités de localiser des chaînes de contacts défectueuses, c'est-à-dire des colonnes métalliques involontairement non connectées au substrat (voir notamment Li et al, fig. 1-2). En aucun cas n'est évoquée la possiblité d'enregistrer volontairement une information dans une colonne métallique en la connectant ou pas au substrat par le biais d'un élément de sélection et d'un élément capacitif.

### Résumé

La présente invention vise un procédé de stockage de façon définitive d'une image au niveau d'un circuit intégré, l'image restant accessible lorsque le circuit intégré est hors service, le stockage de l'image pouvant être réalisé de façon simple et à coût réduit à une échelle industrielle.

Un autre objet vise à permettre le stockage de l'image au niveau du circuit intégré après la fabrication du circuit intégré, et éventuellement après des étapes de test et/ou d'assemblage du circuit intégré.

Un autre objet vise à rendre la lecture de l'image stockée au niveau du circuit intégré particulièrement simple.

La présente invention vise également un circuit intégré au niveau duquel est stockée une image de façon définitive, l'image restant accessible lorsque le circuit intégré est hors service, la lecture de l'image pouvant être réalisée de façon simple.

Pour atteindre tout ou partie de ces objets ainsi que d'autres, un mode de réalisation de la présente invention prévoit un circuit intégré comprenant un substrat d'un matériau semiconducteur ; des premiers pixels constitués chacun d'une première portion métallique d'un premier niveau de métallisation ou de vias, reliée au substrat ; des seconds pixels constitués chacun d'une première portion métallique dudit premier niveau de métallisation ou de vias, séparée du substrat par au moins une portion isolante ; et pour chaque pixel, un élément de couplage capacitif reliant ledit pixel à un élément de sélection.

Selon un mode de réalisation de la présente invention, chaque pixel est relié, par un chemin électrique, à une seconde portion métallique d'un second niveau de métallisation plus proche du substrat que le premier niveau, dans lequel, pour chacun des premiers pixels, la seconde portion métallique associée est reliée au substrat, et dans lequel, pour chacun des seconds pixels, la seconde portion métallique associée est séparée du substrat par au moins une portion isolante.

Selon un mode de réalisation de la présente invention, à chaque pixel correspond un attribut de luminance et/ou de chrominance à deux états, dans lequel, pour chaque premier pixel, l'attribut correspondant est à un premier état et dans lequel, pour chaque second pixel, l'attribut correspondant est à un second état.

Selon un mode de réalisation de la présente invention, pour chaque pixel, l'élément de couplage capacitif associé relie la seconde portion associée à un élément de sélection.

Selon un mode de réalisation de la présente invention, l'élément de couplage capacitif est un transistor MOS comprenant des première et seconde grilles, la seconde grille étant flottante et étant reliée à la seconde portion associée, la première grille étant reliée à l'élément de sélection.

Selon un mode de réalisation de la présente invention, l'élément de couplage capacitif est une capacité MOS comprenant des première et seconde armatures, la première armature étant reliée à la seconde portion associée et la seconde armature étant reliée à l'élément de sélection.

Selon un mode de réalisation de la présente invention, la seconde portion métallique associée à chaque premier pixel est reliée à la grille d'un premier transistor MOS dont l'isolant de grille est non altéré et dans lequel la seconde portion métallique associée à chaque second pixel est reliée à la grille d'un second transistor MOS dont l'isolant de grille est altéré de façon à être conducteur.

Selon un mode de réalisation de la présente invention, ledit élément de sélection est une première borne de conduction d'un transistor MOS de puissance dont la seconde borne de conduction est reliée à une borne d'alimentation de potentiel haut du circuit et dont la grille est adaptée à recevoir un signal de sélection.

Un mode de réalisation de la présente invention prévoit un procédé de stockage d'une image dans un circuit intégré comprenant un substrat d'un matériau semiconducteur, des pixels constitués de premières portions métalliques d'un premier niveau de métallisation ou de vias, chaque pixel étant séparé du substrat par au moins une portion isolante, et chaque pixel étant relié à un élément de sélection par l'intermédiaire d'un élément de couplage capacitif, ce procédé comportant une étape d'application d'une tension entre certains pixels et le substrat, par l'intermédiaire de l'élément de couplage capacitif correspondant, pour altérer ladite portion isolante de façon à relier électriquement ces pixels au substrat.

Selon un mode de réalisation de la présente invention, chaque pixel est relié par un chemin électrique à une seconde portion métallique d'un second niveau de métallisation, plus proche du substrat que le premier niveau, chaque seconde portion métallique étant séparée du substrat par ladite au moins une portion isolante, et dans lequel, pour lesdits certains pixels, ladite tension est appliquée, par l'intermédiaire de l'élément de couplage capacitif associé, entre la seconde portion métallique associée et le substrat.

### Brève description des dessins

Ces objets, caractéristiques et avantages, ainsi que d'autres seront exposés en détail dans la description suivante d'exemples de réalisation particuliers faite à titre non-limitatif en relation avec les figures jointes parmi lesquelles :
la figure 1 est une vue de dessus schématique d'un circuit intégré selon un exemple de réalisation de l'invention ;
la figure 2 est une section du circuit intégré de la figure 1 selon la ligne A-A ;
la figure 3 est une image obtenue lors d'une opération de lecture de l'image stockée au niveau du circuit de la figure 1 ;
les figures 4A à 4D représentent les structures obtenues à des étapes successives d'un procédé de fabrication du circuit de la figure 2 selon un exemple de réalisation de l'invention ;
la figure 5 représente un schéma électrique d'un circuit intégré selon un autre exemple de réalisation de l'invention ;
la figure 6 est une section partielle et schématique du circuit intégré de la figure 5 ;
les figures 7A à 7F représentent les structures obtenues à des étapes successives d'un procédé de fabrication du circuit de la figure 6 selon un exemple de réalisation de l'invention ;
la figure 8 représente un schéma électrique d'un circuit intégré selon un autre exemple de réalisation de l'invention ;
la figure 9 est une section partielle et schématique du circuit de la figure 8 ;
la figure 10 représente un schéma électrique d'un circuit intégré selon un autre exemple de réalisation de l'invention ; et
la figure 11 est une section partielle et schématique du circuit de la figure 10.

### Description détaillée

Par souci de clarté, seuls les étapes et éléments qui sont utiles à la compréhension de l'invention ont été représentés et seront décrits. En outre, de mêmes éléments ont été désignés par de mêmes références aux différentes figures et, de plus, comme cela est habituel dans la représentation des circuits intégrés, les diverses figures ne sont pas tracées à l'échelle.

Dans la suite de la description, on appelle niveau de métallisation l'ensemble des pistes métalliques formées simultanément au cours du procédé de fabrication du circuit intégré. Il peut s'agir de pistes métalliques reposant à la surface d'une couche isolante ou affleurant à la surface d'une couche isolante. On appelle via une portion conductrice traversant une couche isolante et reliant une piste métallique d'un niveau de métallisation donné à une piste métallique d'un niveau de métallisation adjacent. On appelle niveau de vias l'ensemble des vias formés simultanément au cours du procédé de fabrication du circuit intégré. Des vias peuvent être formés simultanément aux pistes métalliques d'un niveau de métallisation donné. Dans ce cas, les niveaux de via de métallisation sont confondus.

La présente invention vise à stocker une image au niveau d'une portion d'un circuit intégré au moyen de pixels formés par des portions métalliques d'un même niveau de métallisation ou d'un même niveau de via, de préférence le dernier niveau ou l'avant-dernier niveau de métallisation ou le niveau de via intermédiaire entre les dernier et avant-dernier niveaux de métallisation. A chaque pixel est associé un attribut de chrominance et/ou de luminance pouvant prendre deux états. L'image est stockée en laissant flottants les pixels ou en les reliant électriquement au substrat lors d'une opération d'écriture. La lecture de l'image peut être réalisée par des techniques d'imagerie adaptées permettant de distinguer les pixels flottants des pixels qui ne le sont pas. Il s'agit, par exemple, de techniques d'imagerie par contraste de potentiel.

La figure 1 est une vue de dessus, partielle et schématique, d'un circuit intégré 10 selon un exemple de réalisation de l'invention et la figure 2 est une section du circuit 10 de la figure 1 selon la ligne A-A.

Le circuit 10 comprend un substrat 12 d'un matériau semiconducteur, par exemple du silicium polycristallin, non dopé ou dopé de type P, ayant une face supérieure 13. Le substrat 12 comprend des zones actives, par exemple des zones dopées de type N, qui s'étendent dans le substrat 12 depuis la face supérieure 13 et qui ont une forme allongée. A titre d'exemple, quatre zones actives C₁ à C₄ parallèles sont représentées en figure 1 en traits mixtes et deux zones actives C₁ et C₂ adjacentes sont représentées en figure 1. Les zones actives C₁ à C₄ sont séparées par des régions isolantes 16. Une couche isolante 18 recouvre la face 13. La couche isolante 18 est recouverte d'un empilement de couches isolantes INS₁ à INS₄.

Dans le présent exemple de réalisation, le circuit intégré 10 comprend des portions métalliques formées dans quatre niveaux de métallisation différents M*ₖ* où k est un entier variant de 1 à 4. Les portions métalliques du premier niveau de métallisation M₁ sont les plus proches du substrat 12 et les portions métalliques du dernier niveau de métallisation M₄ sont les plus éloignées du substrat 12. A titre d'exemple, les pistes conductrices des niveaux de métallisation M₁ à M₃ sont en cuivre et les pistes métalliques du dernier niveau de métallisation M₄ sont en aluminium. Dans le présent exemple de réalisation, les portions métalliques du niveau de métallisation Mₖ sont disposées sur la couche isolante INS_{K}.

Des pixels Pix_{i,j}, où i et j sont des entiers qui varient dans le présent exemple entre 1 et 4, sont formés à l'aplomb des zones actives C₁ à C₄. En figure 1, on a représenté chaque pixel Pix_{i,j} par un carré en traits pointillés. A titre d'exemple, les pixels sont agencés en rangées et en colonnes. Les zones actives C₁ à C₄ sont orientées selon les colonnes de pixels, à chaque zone active Cj étant associés quatre pixels Pixᵢ,ⱼ, Pix₂,ⱼ, Pix₃,ⱼ et Pix₄,ⱼ.

Dans le présent exemple de réalisation, chaque pixel Pix_{i,j} est constitué par une portion métallique de l'avant-dernier niveau de métallisation M₃. Chaque portion métallique Pix_{i,j} est reliée à une portion métallique MP_{i,j} du premier niveau de métallisation M₁ par un chemin électrique EP_{i,j} constitué par la mise en série de vias et d'une portion métallique du niveau de métallisation M₂. Chaque portion métallique MP_{i,j} est connectée à un via V_{i,j} traversant la première couche isolante INS₁ et s'étendant jusqu'à la couche isolante 18. On associe à chaque pixel Pix_{i,j} une zone d'écriture du pixel WZ_{i,j} qui correspond à la partie de la couche isolante 18 interposée entre le via V_{i,j} et la zone active Cⱼ.

Des pistes métalliques parallèles R₁ à R₄ du dernier niveau de métallisation M₄ s'étendent selon les rangées de pixels. Chaque piste métallique Rᵢ est connectée, par des vias V'_{i,j} traversant la couche isolante INS₃, aux pixels Pix_{i,j}, où j varie de 1 à 4. Autrement dit, chaque piste R₁ et R₄ est connectée à l'ensemble des pixels d'une même rangée.

Le stockage d'une image est obtenu, pour chaque pixel Pix_{i,j}, au cours d'une opération d'écriture réalisée une fois que le circuit intégré 10 est fabriqué. Il consiste à altérer, pour certains pixels Pix_{i,j}, la zone d'écriture WZ_{i,j} de façon à la rendre conductrice. Pour chaque pixel Pix_{i,j} pour lequel la zone d'écriture WZ_{i,j} n'est pas altérée, la base du via V_{i,j} est isolée électriquement du substrat 12. Pour chaque pixel Pix_{i,j} pour lequel la zone d'écriture WZ_{i,j} est altérée, tout se passe comme si la base du via V_{i,j} est connectée électriquement à la zone active Cj sous-jacente. A titre d'exemple, en figure 1, les pixels Pix_{1,1}, Pix_{4,2} et Pix_{3,4} ont leur base isolée du substrat 12 par la couche isolante 18 et les autres pixels ont leur base connectée au substrat 12. En figure 1, on a représenté la zone d'écriture WZ_{1,2} altérée par une région hachurée.

Pour chaque pixel Pix_{i,j} pour lequel on souhaite altérer la portion de la couche isolante 18 séparant le via V_{i,j} de la zone active Cⱼ sous-jacente, l'opération d'écriture consiste à mettre la piste métallique R₁ associée à un potentiel de référence haut VPP et à mettre la zone active Cⱼ à un potentiel de référence bas, les autres zones actives étant maintenues au potentiel VPP. A titre d'exemple, le potentiel de référence bas correspond à la masse GND et est égal à 0 V et le potentiel de référence haut VPP, référencé par rapport à la masse GND, est supérieur à une dizaine de volts, par exemple de l'ordre de 12 V. Les potentiels de référence haut et bas VPP et GND sont choisis pour que la tension qui s'établit entre le via V_{i,j} et la zone active Cⱼ sous-jacente soit suffisamment élevée pour entraîner le claquage de la portion intermédiaire de la couche isolante 18 et donc assurer la connexion électrique entre la base du via V_{i,j} et la zone active Cⱼ. A titre d'exemple, la couche isolante 18 peut correspondre à une bicouche ayant une épaisseur de l'ordre de 60 nm comprenant une couché d'oxyde de l'ordre de 20 nm recouverte d'une couche de nitrure de l'ordre de 40 nm. Une tension entre le via V_{i,j} et la zone active Cⱼ supérieure à une dizaine de volts permet d'assurer le claquage de la zone d'écriture WZ_{i,j}. Les claquages des zones d'écriture WZ_{i,j} associées à plusieurs pixels Pix_{i,j} de la même rangée peuvent être réalisés simultanément. Une fois l'opération d'écriture achevée, le circuit intégré 10 peut être utilisé normalement.

Une opération de lecture d'une image est réalisée en retirant les pistes métalliques R₁ à R₄ du dernier niveau de métallisation M₄, les vias V_{i,j} et la couche isolante INS₄ de façon à exposer les portions métalliques Pix_{i,j} du niveau de métallisation M₃. Le retrait des pistes métalliques R₁ à R₄ fait que chaque pixel Pix_{i,j}, pour lequel la zone d'écriture WZ_{i,j} associée n'est pas altérée, est électriquement flottant. Chaque pixel Pix_{i,j}, pour lequel la zone d'écriture WZ_{i,j} associée a été altérée, est électriquement connecté à la zone active Cⱼ correspondante. Selon une variante, seules les pistes métalliques R₁ à R₄ sont retirées. Dans ce cas, les vias V_{i,j} jouent le rôle de pixels.

Une opération de lecture peut être réalisée par des procédés d'imagerie par contraste de potentiel ou procédés PVC (acronyme anglais pour Passive Voltage Contrast). De tels procédés sont décrits, par exemple, dans l'ouvrage intitulé "Microelectronics Failure Analysis: Desk Reference Fifth Edition" publié en 2004 par EDFAS Desk Reference Commitee. Un procédé PVC consiste à projeter un faisceau d'ions ou d'électrons sur une surface à observer et à détecter les électrons secondaires de faible énergie qui sont émis par la surface. Une image est obtenue dont le contraste dépend de la quantité d'électrons détectés. Dans le cas de structures isolées électriquement, peu d'électrons secondaires sont détectés. En effet, des charges positives tendent à s'accumuler en surface de ces structures attirant ainsi les électrons secondaires émis qui sont recapturés. Ces structures apparaissent sombres sur l'image obtenue. Dans le cas de structures reliées électriquement à une source d'un potentiel de référence bas, par exemple la masse, de nombreux électrons secondaires sont détectés car il n'y a pas de recapturation des électrons. Ces structures apparaissent plus claires.

Le procédé PVC est mis en oeuvre en mettant le substrat 12 au potentiel de référence bas GND. Ceci peut être réalisé même si le circuit intégré 10 est hors service. La mise au potentiel bas du substrat 12 permet l'évacuation des charges présentes dans les pixels Pix_{i,j} électriquement reliés à la zone active Cⱼ correspondante en raison des courants de fuite au niveau de la jonction entre la zone active Cⱼ et le substrat 12. Les pixels Pix_{i,j} apparaissent donc avec une teinte claire sur l'image obtenue tandis que les pixels Pix_{i,j} électriquement isolés apparaissent avec une teinte sombre. La couche isolante INS₃ apparaît également avec une teinte sombre sur l'image obtenue. Sur l'image obtenue, chaque pixel apparaît donc selon un attribut de luminance à deux états : clair ou sombre.

La figure 3 représente une image obtenue par la mise en oeuvre d'un procédé de lecture de l'image stockée au niveau du circuit 10 de la figure 1. Les pixels Pix_{i,j} sont représentés par des carrés. A titre d'exemple, seuls les pixels Pix_{i,j}, Pix_{4,2} et Pix_{3,4}, marqués par une croix en figure 3, sont isolés du substrat 12 par la couche isolante 18 et apparaissent avec une teinte sombre sur l'image obtenue.

A titre de variante, l'opération de lecture peut être mise en oeuvre par un procédé par microscopie à force atomique à pointe conductrice ou procédé C-AFM (acronyme anglais pour Conduction Atomic Force Microscopy). Un procédé C-AFM consiste à déplacer une pointe au-dessus de la surface du circuit 10, la pointe étant maintenue à distance de la surface du circuit 10. Le substrat 12 est mis à un potentiel de référence bas et la pointe est mise à un potentiel de référence haut. On mesure l'intensité du courant traversant la pointe. L'intensité mesurée varie selon que la pointe est au contact d'un pixel flottant ou d'un pixel relié électriquement au substrat. Une image est obtenue, par exemple avec un niveau de gris ou avec une nuance de couleur qui dépend de l'intensité du courant mesuré.

Les pixels Pix_{i,j} peuvent être agencés en rangées et en colonnes de façon à former un écran matriciel. A titre de variante, les pixels Pix_{i,j} peuvent être agencés à la façon de segments ou de diodes d'un afficheur numérique. A titre de variante, les pixels Pix_{i,j} peuvent avoir des formes différentes les uns des autres.

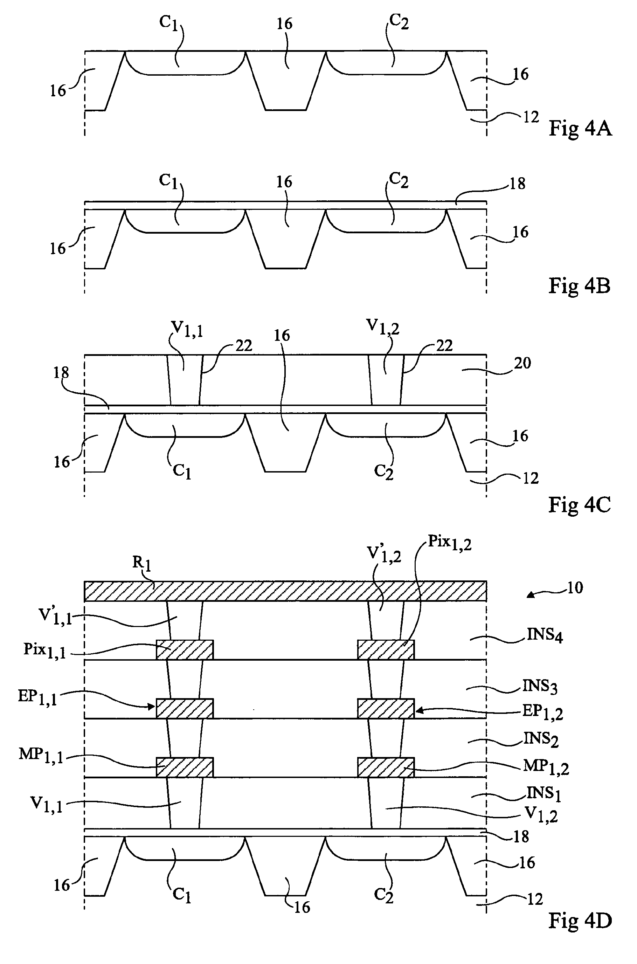

Les figures 4A à 4D sont des sections analogues à la figure 2 de structures obtenues à des étapes successives d'un procédé de fabrication du circuit 10 selon un exemple de réalisation de l'invention.
La figure 4A représente la structure obtenue après avoir formé dans le substrat 12 les zones actives C₁ et C₂ séparées par les régions isolantes 16. Les régions isolantes 16 sont, par exemple, formées par un procédé STI (Shallow Trench Isolation).
La figure 4B représente la structure obtenue après avoir déposé une couche d'oxyde puis une couche de nitrure formant la couche isolante 18.
La figure 4C représente la structure obtenue après avoir déposé la couche isolante INS₁, par exemple en oxyde de silicium, sur la couche isolante 18, après avoir gravé des ouvertures 22 dans la couche INS₁ et après avoir formé les vias V_{1,1} et V_{1,2} dans les ouvertures 22. La couche isolante 18 joue le rôle de couche d'arrêt de gravure lors de la gravure des ouvertures 22. De ce fait, les vias V_{1,1} et V_{1,2} formés dans les ouvertures 22 ne sont pas en contact électrique avec les zones actives C₁, C₂ sous-jacentes.
La figure 4D représente la structure obtenue après le dépôt des couches isolantes INS₂, INS₃ et INS₄ et la formation des chemins électriques EP₁,₁ et EP_{1,2}, des pixels Pix_{1,1} et Pix_{1,2}, des vias V'_{1,1} et V'_{1,2} et de la piste métallique R₁. On obtient alors un circuit intégré dans lequel tous les pixels Pix_{i,j} sont flottants. On réalise alors l'étape d'écriture décrite précédemment dans laquelle la couche isolante 18 est altérée au niveau de certains pixels.

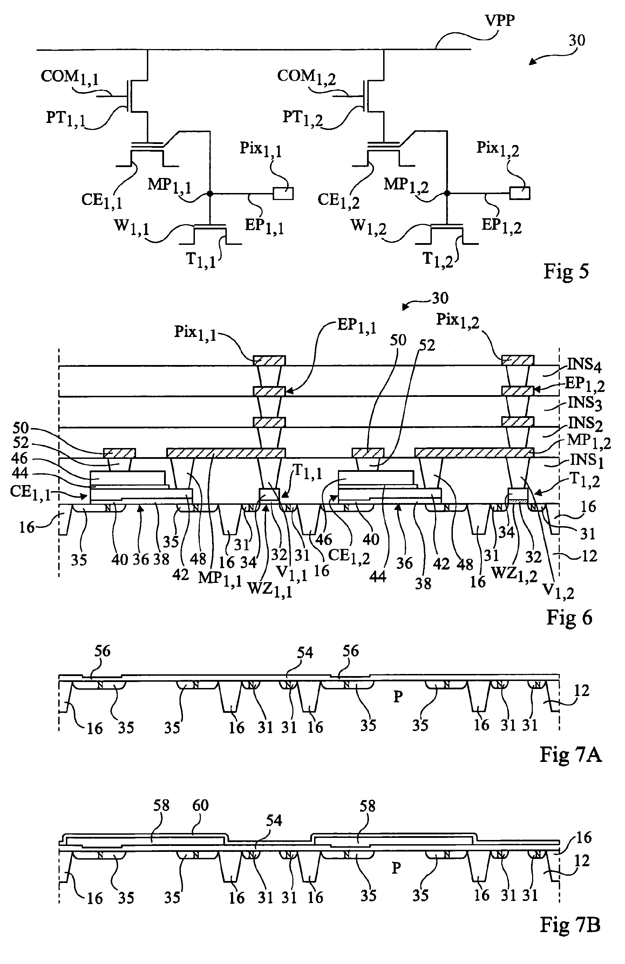

La figure 5 représente un schéma électrique partiel d'un circuit intégré 30 selon un autre exemple de réalisation de l'invention. Dans le présent exemple de réalisation, chaque pixel Pix_{i,j} est formé par une portion métallique du dernier niveau de métallisation M₄. En figure 5, on a représenté deux pixels Pix_{1,1} et Pix_{1,2} d'une matrice de pixels. Dans le présent exemple de réalisation, pour chaque pixel Pix_{i,j}, la zone d'écriture WZ_{i,j} associée correspond à l'isolant de grille d'un transistor MOS T_{i,j}. Le transistor T_{i,j} est dit transistor à oxyde mince ou transistor basse tension. De plus, chaque portion métallique MP_{i,j} est reliée par un élément de couplage CE_{i,j} à une borne de conduction (source ou drain) d'un transistor MOS de puissance PT_{i,j} dont l'autre borne de conduction est reliée à une source du potentiel de référence haut VPP. Le transistor PT_{i,j} est dit transistor à oxyde épais ou transistor haute tension. Le transistor PT_{i,j} correspond, par exemple, à un transistor MOS à canal N. La grille du transistor PT_{i,j} reçoit un signal de commande COM_{i,j}. L'élément de couplage CE_{i,j} permet, comme cela sera décrit plus en détail par la suite, de réaliser l'opération d'écriture. De façon avantageuse, l'élément de couplage CE_{i,j} peut correspondre à un composant électronique classique tel qu'un élément mémoire d'une mémoire non volatile programmable et effaçable électriquement ou mémoire EEPROM (Electrically Erasable Programmable Read Only Memory) ayant la structure d'un transistor MOS à double grille dont une grille est flottante. La portion métallique MP_{i,j} est reliée à la grille flottante de l'élément mémoire CE_{i,j} et le transistor de puissance PT_{i,j} est relié à la grille de commande de l'élément mémoire CE_{i,j}. Par rapport au circuit 10, le circuit 30 ne comprend pas les zones actives Cⱼ. Le circuit 30 présente l'avantage d'utiliser des composants électroniques classiques.
La figure 6 est une section analogue à la figure 2 des pixels Pix_{1,1} et Pix_{1,2}, des chemins électriques EP_{1,1}, EP_{1,2} et des éléments de couplage CE_{1,1} et CE_{1,2} du circuit intégré 30. Chaque transistor T_{i,j} comprend des régions dopées 31 de type N s'étendant dans le substrat 12 de part et d'autre d'une portion isolante 32 disposée sur le substrat 12, par exemple une portion d'oxyde de silicium mince ayant une épaisseur de quelques nanomètres, par exemple de 2 ou 3 nm. Une portion 34 d'un matériau semiconducteur, par exemple du silicium polycristallin, recouvre la portion isolante 32. Les régions 31 forment les régions de source et de drain du transistor T_{i,j}. La portion isolante 32 forme l'isolant de grille du transistor T_{i,j} et correspond à la zone d'écriture WZ_{i,j}. La portion semiconductrice 34 forme la grille du transistor T_{i,j}. Une couche isolante, non représentée, peut recouvrir les pixels Pix_{i,j}.

Chaque élément mémoire CE_{i,j} comprend des régions dopées 35 de type N s'étendant dans le substrat 12 de part et d'autre d'une portion isolante 36 disposée sur le substrat 12. La portion isolante 36 comprend une région épaisse 38, ayant par exemple une épaisseur de l'ordre de 20 nm et une région plus mince 40, ayant par exemple une épaisseur de l'ordre d'une dizaine de nanomètres. Une portion conductrice 42, par exemple en silicium polycristallin, recouvre la portion isolante 36. La portion 42 forme la grille flottante de l'élément mémoire CE_{i,j}. Une portion isolante 44 recouvre partiellement la portion semiconductrice 42. Une portion semiconductrice 46 recouvre la portion isolante 44. La portion 46 forme la grille de commande de l'élément mémoire CE_{i,j}.

Par rapport au circuit 10, pour chaque pixel Pix_{i,j} du circuit 30, le via V_{i,j} est connecté à la grille 32 du transistor T_{i,j}. La piste métallique MP_{i,j} est connectée au via V_{i,j} et, en outre, à un via 48 dont la base est connectée à la grille flottante 42 de l'élément mémoire CE_{i,j}. On a également représenté en figure 6, associée à chaque pixel Pix_{i,j}, une piste métallique 50 du premier niveau de métallisation connectée, par un via 52 traversant la couche isolante INS₁, à la grille de commande 46 de l'élément mémoire CE_{i,j}.

L'écriture d'une image dans le circuit intégré 30 est réalisée en altérant l'isolant de grille 32 du transistor T_{i,j} de certains pixels Pix_{i,j} de sorte que le via V_{i,j} du pixel Pix_{i,j} est relié électriquement au substrat 12 sous-jacent. En figure 6, l'isolant de grille 32 du transistor T_{1,2} a été représenté hachuré pour montrer qu'il a été altéré.

L'étape d'écriture est réalisée en mettant le substrat 12 au potentiel de référence bas GND et en rendant passant le transistor PT_{i,j} de chaque pixel Pix_{i,j} que l'on souhaite connecter électriquement au substrat 12. Le potentiel de la grille de commande 46 de l'élément mémoire CE_{i,j} tend alors à s'élever sensiblement au potentiel de référence haut VPP. L'empilement des portions conductrices et isolantes 36, 42, 44 et 46 de l'élément mémoire CE_{i,j} forment un pont capacitif. Il en résulte une élévation du potentiel de la grille flottante 42 de l'élément mémoire CE_{i,j} et donc une élévation du potentiel de la grille 34 du transistor T_{i,j} à une valeur suffisante pour entraîner le claquage de l'isolant de grille 32 du transistor T_{i,j}. Par exemple, une tension entre le via V_{i,j} et le substrat 12 supérieure à une dizaine de volts est suffisante pour obtenir le claquage d'un isolant de grille 32 en oxyde de silicium ayant une épaisseur de quelques nanomètres. Pour améliorer l'élévation du potentiel de la grille 34 du transistor T_{i,j}, les régions de source et de drain 35 de l'élément mémoire CE_{i,j} peuvent être amenées à VPP pendant l'opération d'écriture.

Après l'opération d'écriture, certains pixels Pix_{i,j} sont donc électriquement isolés du substrat 12 par le transistor T_{i,j} dont l'isolant de grille 32 est laissé intact et par l'élément mémoire CE_{i,j} dont la grille 42 est flottante. D'autres pixels Pix_{k,l} sont électriquement reliés au substrat 12 par l'intermédiaire du transistor T_{k,l} dont l'isolant de grille 32 est altéré.

L'étape de lecture est réalisée comme cela a été décrit précédemment avec le circuit 10 des figures 1 et 2 à la différence qu'il suffit d'exposer les portions métalliques du dernier niveau de métallisation. En effet, un procédé PVC ou C-AFM peut être réalisé directement au niveau des portions métalliques du dernier niveau de métallisation.

Selon une variante du circuit 30, les transistors T_{i,j} peuvent être remplacés par une structure analogue au circuit 10 dans laquelle chaque via V_{i,j} est initialement isolé du substrat 12 par une couche isolante 18 qui est altérée ou laissée telle quelle lors de l'opération d'écriture.
Les figures 7A à 7F sont des figures analogues à la figure 6 et représentent des structures obtenues à des étapes successives d'un procédé de fabrication du circuit 30 selon un exemple de réalisation de l'invention.
La figure 7A représente la structure obtenue après les étapes suivantes :
   former dans le substrat 12 les régions de séparation 16 et les régions 31, 35 dopées de type N ;
   déposer sur l'ensemble du circuit une couche isolante 54, par exemple une couche d'oxyde de silicium ayant une épaisseur de l'ordre de 20 nanomètres ; et
   former dans la couche d'oxyde 54 des portions amincies 56 aux emplacements des éléments mémoire. Chaque portion amincie 56 a, par exemple, une épaisseur inférieure à 10 nanomètres.
   La figure 7B représente la structure obtenue après avoir déposé sur l'ensemble du circuit une couche de silicium polycristallin, ayant, par exemple, une épaisseur de 100 nanomètres, après avoir gravé la couche de silicium polycristallin pour délimiter, au niveau des emplacements de chaque élément mémoire, une portion 58 de silicium polycristallin et après avoir recouvert l'ensemble du circuit d'une couche isolante 60 ayant une épaisseur de l'ordre de 20 nanomètres, correspondant, par exemple, à une couche d'oxyde de silicium ou à une structure multicouche comprenant un empilement d'une couche d'oxyde de silicium, une couche de nitrure de silicium et une couche d'oxyde de silicium.

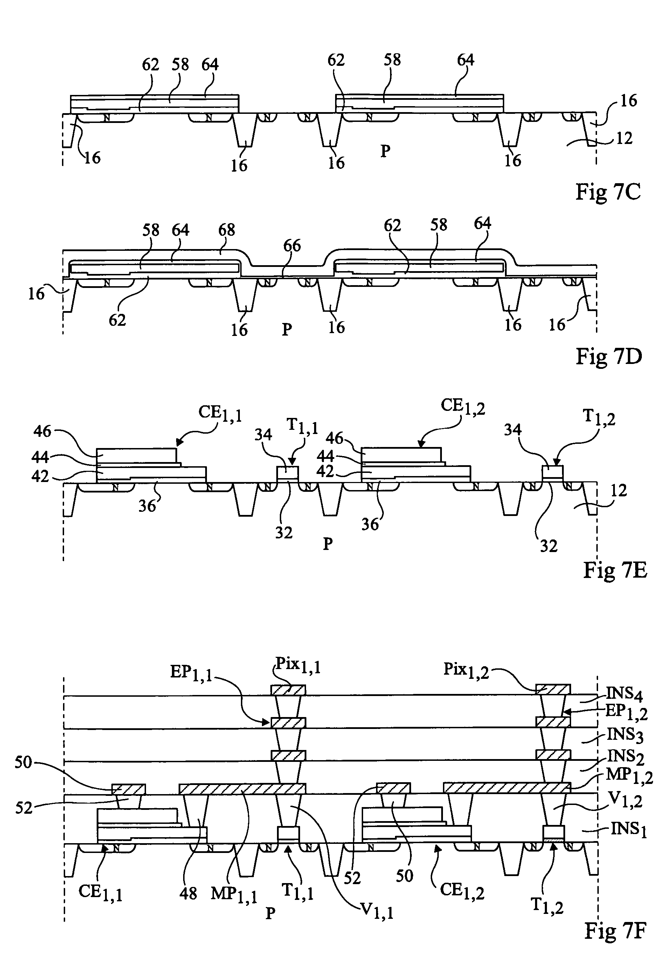

   La figure 7C représente la structure obtenue après avoir gravé les couches isolantes 54, 60 de façon à délimiter, aux emplacements des éléments mémoire, une portion 62 de la couche isolante 54 et une portion 64 de la couche isolante 60 de part et d'autre de la portion de silicium polycristallin 58, les couches isolantes 54, 60 étant retirées aux emplacements des transistors.
   La figure 7D représente la structure obtenue après avoir formé une couche isolante 66, par exemple une couche d'oxyde de silicium ayant une épaisseur de quelques nanomètres sur les parties du circuit non recouvertes des portions isolantes 64 et après avoir recouvert l'ensemble du circuit d'une couche de silicium polycristallin 68 ayant, par exemple, une épaisseur de 100 à 200 nanomètres.
   La figure 7E représente la structure obtenue après avoir réalisé les étapes consistant à graver la couche de silicium polycristallin 68, les portions isolantes 64, les portions de silicium polycristallin 58, les portions isolantes 62, et la couche isolante 66, de façon à délimiter, pour chaque élément mémoire CE_{i,j}, la portion isolante 36, la grille flottante 42, la portion isolante 44 et la grille de commande 46, et de façon à délimiter pour chaque transistor T_{i,j}, l'isolant de grille 32 et la grille 34.
   La figure 7F représente la structure obtenue après avoir recouvert la structure précédente de l'empilement de couches isolantes INS₁, INS₂, INS₃ et INS₄ tout en formant les vias et les portions métalliques associés. A la fin du procédé décrit précédemment, chaque pixel Pix_{i,j} est flottant. Le procédé se poursuit par l'étape d'écriture.

Dans l'exemple de réalisation décrit en relation avec les figures 5 à 7F, l'élément mémoire CE_{i,j} correspond à un élément mémoire classique d'une mémoire EEPROM. Dans ce cas, l'élément mémoire CE_{i,j} est associé à un transistor de sélection, non représenté, et peut être utilisé, après une opération d'écriture, pour vérifier si l'opération d'écriture s'est déroulée correctement. En effet, pour un pixel Pix_{i,j} pour lequel l'isolant de grille 32 du transistor T_{i,j} a été altéré, il n'est plus possible de stocker des charges dans la grille flottante 42 de l'élément mémoire CE_{i,j} puisque ces charges vont être évacuées vers le substrat 12 par le transistor T_{i,j}. L'absence de charges dans la grille flottante 42 de l'élément mémoire CE_{i,j} peut être détectée par une opération de lecture de l'élément mémoire CE_{i,j}.

Selon un avantage du présent exemple de réalisation, l'opération d'écriture d'une image est simplifiée par rapport au circuit 10 de la figure 1. En effet, lors de l'étape d'écriture, l'ensemble du substrat est mis à un même potentiel de référence, et chaque pixel peut être adressé individuellement grâce à l'élément de sélection PT_{i,j} qui lui est associé. Ceci permet notamment de réaliser des opérations d'écriture en parallèle sur des pixels de lignes et colonnes différentes.

Selon un autre avantage de cet exemple de réalisation, l'opération de lecture de l'image est simplifiée par rapport au circuit 10 de la figure 1. En effet, chaque pixel est formé par une portion métallique du dernier niveau de métallisation. Ainsi, les pixels sont directement accessibles en lecture, sans étape préalable de retrait de pistes métalliques.

Selon une variante de réalisation, la portion isolante 38 de l'élément mémoire CE_{i,j} ne comprend pas de zone amincie. En outre, l'élément mémoire CE_{i,j} ne comprend pas de régions de source et de drain 35 et le transistor T_{i,j} ne comprend pas de régions de source et de drain 31.

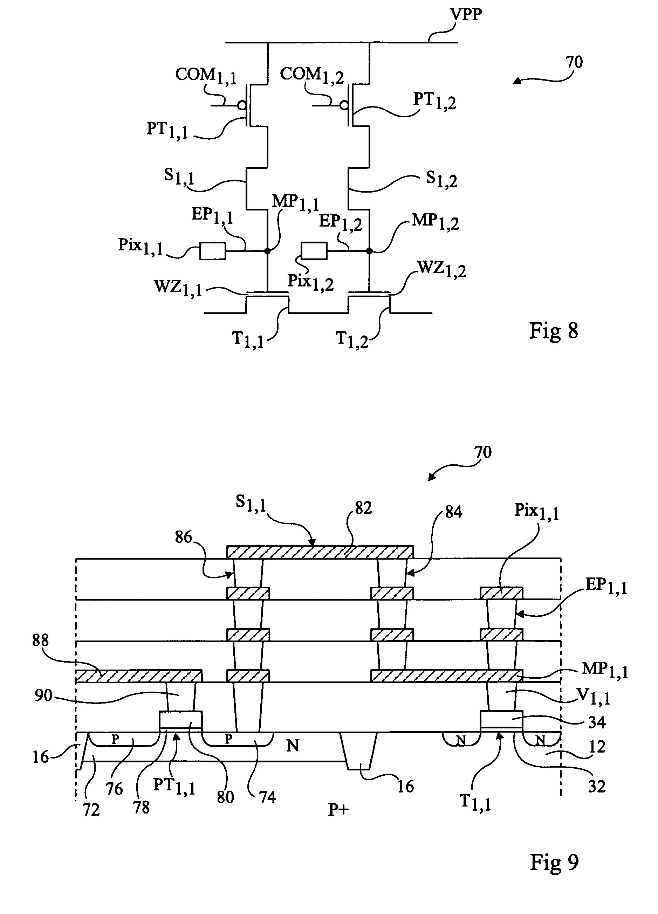

La figure 8 représente un schéma électrique partiel d'un circuit intégré 70 selon un autre exemple de réalisation de l'invention. Dans le présent exemple de réalisation, les pixels Pix_{i,j} correspondent à des portions métalliques de l'avant-dernier niveau de métallisation M₃. En figure 8, on a représenté deux pixels Pix_{1,1} et Pix_{1,2} d'une matrice de pixels. Le schéma électrique du circuit 70 est analogue au schéma électrique du circuit 30 de la figure 5 à la différence que l'élément de couplage CE_{i,j} est remplacé par un chemin de conduction S_{i,j} reliant électriquement la portion métallique MP_{i,j} à une borne de conduction du transistor MOS de puissance PT_{i,j}, l'autre borne de conduction du transistor PT_{i,j} étant reliée à la source du potentiel de référence haut VPP. Le transistor PT_{i,j} correspond, par exemple, à un transistor MOS à canal P. Le chemin de connexion S_{i,j} correspond à la mise en série de vias et de portions métalliques de différents niveaux de métallisation. En particulier, le chemin de conduction S_{i,j} comprend une portion métallique du dernier niveau de métallisation. Le procédé de fabrication du circuit 70 reprend certaines étapes du procédé de fabrication du circuit 30, le chemin de connexion S_{i,j} étant formé parallèlement au chemin électrique EP_{i,j}.

Comme pour le circuit 30 de la figure 5, une opération d'écriture consiste à altérer, pour certains pixels Pix_{i,j}, l'isolant de grille du transistor T_{i,j} associé. Pour ce faire, le transistor de puissance PT_{i,j} associé est rendu passant et le substrat 12 est mis au potentiel de référence bas. Il en résulte une élévation du potentiel de la grille du transistor T_{i,j}. La tension obtenue entre la grille du transistor T_{i,j} et le substrat sous-jacent est suffisamment élevée pour entraîner le claquage de l'isolant de grille du transistor T_{i,j}. Le transistor PT_{i,j} est un transistor de puissance adapté à accepter la tension VPP.

Comme pour le circuit 10 représenté en figure 2, une opération de lecture du circuit 70 est réalisée en retirant les portions métalliques du dernier niveau de métallisation. On obtient alors une interruption du chemin de conduction S_{i,j}. De ce fait, chaque pixel Pix_{i,j} dont la zone d'écriture W_{i,j} n'a pas été altérée est flottant tandis que chaque pixel Pix_{k,l} dont la zone d'écriture W_{k,l} a été altérée est connecté électriquement au substrat 12. Le substrat 12 est alors mis au potentiel de référence bas GND et un procédé de type PVC ou C-AFM peut être mis en oeuvre comme cela a été décrit précédemment.

La figure 9 est une section du pixel Pix_{1,1}, du chemin de conduction S_{1,1} et du transistor PT_{1,1}. Le transistor PT_{1,1} est, à titre d'exemple, un transistor MOS de type P formé au niveau d'un caisson 72 de type N qui s'étend dans le substrat 12. Le transistor PT_{1,1} comprend des régions dopées 74, 76 qui s'étendent dans le caisson 72 de part et d'autre d'une portion isolante 78 recouvrant le substrat 12. Une portion conductrice 80 recouvre la portion isolante 78. La région 74 correspond au drain du transistor PT_{1,1} et la région 76 correspond à la source du transistor PT_{1,1}. La région 76 est reliée à la source du potentiel VPP, non représentée en figure 9. A titre d'exemple, le chemin de conduction S_{1,1} comprend une portion métallique 82 du niveau de métallisation M₄ qui est reliée, à une extrémité, à la portion métallique MP_{1,1} par un premier empilement 84 de vias et de portions métalliques des niveaux de métallisation M₂ et M₃ et est reliée, à l'autre extrémité, au drain 74 du transistor PT_{1,1} par un second empilement 86 de vias et de portions métalliques des niveaux de métallisation M₁ à M₃. On a, en outre, représenté en figure 9 une portion métallique 88 du premier niveau de métallisation reliée à la grille 80 du transistor PT_{1,1} par un via 90.

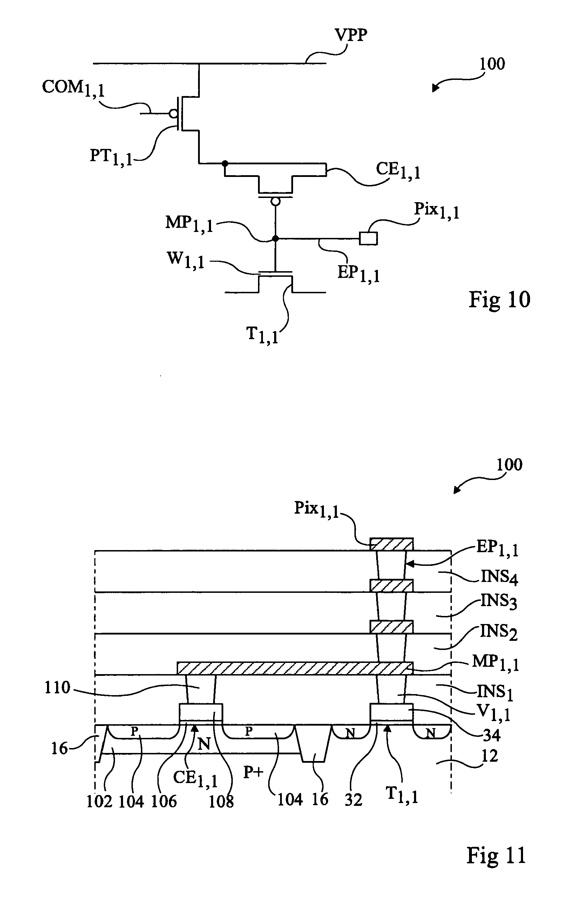

La figure 10 représente un schéma électrique partiel d'un circuit intégré 100 selon un autre exemple de réalisation de l'invention. Dans le présent exemple de réalisation, les pixels Pix_{i,j} correspondent à des portions métalliques du dernier niveau de métallisation M₄. En figure 10, on a représenté un pixel Pix_{1,1} d'une matrice de pixels. Chaque pixel Pix_{i,j} a une structure analogue à celle du circuit 30. Toutefois, pour le circuit 100, l'élément de couplage CE_{i,j} correspond à une capacité MOS. Il s'agit, par exemple, d'un transistor MOS dit à oxyde épais dont les bornes de conduction (source et drain) sont reliées au transistor de puissance PT_{i,j} et dont la grille est reliée au pixel Pix_{i,j}. Le procédé de fabrication du circuit 100 reprend certaines étapes du procédé de fabrication du circuit 30.

Comme pour le circuit 30 de la figure 5, une opération d'écriture d'une image dans le circuit 100 consiste à altérer, pour certains pixels Pix_{i,j}, l'isolant de grille du transistor T_{i,j} associé. Pour ce faire, le transistor de puissance PT_{i,j} associé est rendu passant et le substrat 12 du circuit 100 est mis au potentiel de référence bas GND. Il en résulte une élévation du potentiel de la grille du transistor CE_{i,j} et, par couplage capacitif, une élévation du potentiel aux source et drain de ce transistor. Ceci se traduit par une élévation suffisante du potentiel de la grille du transistor T_{i,j}. La tension entre la grille du transistor T_{i,j} et le substrat 12 sous-jacent est suffisamment élevée pour entraîner le claquage de l'isolant de grille du transistor T_{i,j}.

Une opération de lecture de l'image stockée dans le circuit 100 est réalisée comme pour le circuit 30 de la figure 6, le transistor CE_{i,j} à oxyde épais assurant l'isolation électrique du pixel Pix_{i,j}.

La figure 11 est une section du pixel Pix_{1,1}, du chemin électrique EP_{1,1} et de l'élément de couplage CE_{1,1} associés. L'élément de couplage CE_{1,1} est, à titre d'exemple, un transistor MOS de type P formé au niveau d'un caisson 102 de type N qui s'étend dans le substrat 12. Le transistor CE_{1,1} comprend des régions dopées 104 qui s'étendent dans le caisson 102 de part et d'autre d'une portion isolante 106 recouvrant le substrat 12. Une portion conductrice 108 recouvre la portion isolante 106. Les régions 104 correspondent au drain et à la source du transistor PT_{1,1}. Les régions 104 sont reliées à une borne de conduction du transistor de puissance PT_{1,1}, non représentée. La portion isolante 106 forme l'isolant de grille du transistor CE_{1,1} et la portion conductrice 108 forme la grille du transistor CE_{1,1}. La portion métallique MP_{1,1} associée au pixel Pix_{1,1} est reliée par un via 110 à la grille 108 du transistor CE_{1,1}.

Des modes de réalisation particuliers de la présente invention ont été décrits. Diverses variantes et modifications apparaîtront à l'homme de l'art. En particulier, bien que dans les exemples de réalisation décrits précédemment, les circuits intégrés comprennent quatre niveaux de métallisation, il est clair que la présente invention peut être mise en oeuvre pour un circuit intégré comprenant un nombre différent de niveaux de métallisation.

## Revendications

1. Circuit intégré (10 ; 30 ; 70 ; 100) comprenant :
un substrat (12) d'un matériau semiconducteur,
des premiers et seconds pixels (Pix_{1,1}, Pix_{1,2}) constitués chacun d'une première portion métallique d'un premier niveau de métallisation ou de vias, la première portion métallique de chaque premier pixel étant reliée au substrat et la première portion métallique de chaque second pixel étant séparée du substrat par au moins une portion isolante (18, 32), et
pour chaque pixel (Pix_{1,1}, Pix_{1,2}), un élément de couplage capacitif (CE_{1,1}, CE_{1,2}) reliant ledit pixel à un élément de sélection (PT_{1,1}, PT_{1,2}).

2. Circuit selon la revendication 1, dans lequel chaque pixel (Pix_{1,1}, Pix_{1,2}) est relié, par un chemin électrique (EP_{1,1}, EP_{1,2}), à une seconde portion métallique (MP_{1,1}, MP_{1,2}) d'un second niveau de métallisation plus proche du substrat que le premier niveau, dans lequel, pour chacun des premiers pixels (Pix_{1,2}), la seconde portion métallique associée est reliée au substrat (12), et dans lequel, pour chacun des seconds pixels (Pix_{1,1}), la seconde portion métallique associée est séparée du substrat par au moins une portion isolante (18, 32).

3. Circuit selon la revendication 1 ou 2, dans lequel à chaque pixel (Pix_{1,1}, Pix_{1,2}) correspond un attribut de luminance et/ou de chrominance à deux états, dans lequel, pour chaque premier pixel (Pix_{1,2}), l'attribut correspondant est à un premier état et dans lequel, pour chaque second pixel (Pix_{1,1}), l'attribut correspondant est à un second état.

4. Circuit selon la revendication 2, dans lequel pour chaque pixel (Pix_{1,1}, Pix_{1,2}), l'élément de couplage capacitif (CE_{1,1}, CE_{1,2}) associé relie la seconde portion associée (MP_{1,1}, MP_{1,2}) à un élément de sélection (PT_{1,1}, PT_{1,2}).

5. Circuit (30) selon la revendication 2 ou 4, dans lequel l'élément de couplage capacitif (CE_{1,1}, CE_{1,2}) est un transistor MOS comprenant des première et seconde grilles (42, 46), la seconde grille (42) étant flottante et étant reliée à la seconde portion associée (MP_{1,1}, MP_{1,2}), la première grille (46) étant reliée à l'élément de sélection (PT_{1,1}, PT_{1,2})·

6. Circuit (100) selon la revendication 2 ou 4, dans lequel l'élément de couplage capacitif (CE_{1,1}, CE_{1,2}) est une capacité MOS comprenant des première et seconde armatures (108, 104), la première armature (108) étant reliée à la seconde portion associée (MP_{1,1}, MP_{1,2}) et la seconde armature (104) étant reliée à l'élément de sélection (PT_{1,1}, PT_{1,2}).

7. Circuit selon l'une quelconque des revendications 2 et 4 à 6, dans lequel la seconde portion métallique (MP_{1,1}) associée à chaque premier pixel (Pix_{1,1}) est reliée à la grille (34) d'un premier transistor MOS (T_{1,1}) dont l'isolant de grille (32) est non altéré et dans lequel la seconde portion métallique (MP_{1,2}) associée à chaque second pixel (Pix_{1,2}) est reliée à la grille d'un second transistor MOS (T_{1,2}) dont l'isolant de grille est altéré de façon à être conducteur.

8. Circuit selon l'une quelconque des revendications 1 à 7, dans lequel ledit élément de sélection est une première borne de conduction d'un transistor MOS de puissance (PT_{1,1}, PT_{1,2}) dont la seconde borne de conduction est reliée à une borne d'alimentation de potentiel haut (VPP) du circuit et dont la grille est adaptée à recevoir un signal de sélection.

9. Procédé de stockage d'une image dans un circuit intégré (10 ; 30 ; 70 ; 100) comprenant un substrat (12) d'un matériau semiconducteur, des pixels (Pix_{1,1}, Pix_{1,2}) constitués de premières portions métalliques d'un premier niveau de métallisation ou de vias, chaque pixel étant séparé du substrat par au moins une portion isolante (18, 32), et chaque pixel étant relié à un élément de sélection par l'intermédiaire d'un élément de couplage capacitif, ce procédé comportant une étape d'application d'une tension entre certains pixels (Pix_{1,2}) et le substrat, par l'intermédiaire de l'élément de couplage capacitif correspondant, pour altérer ladite portion isolante de façon à relier électriquement ces pixels au substrat.

10. Procédé selon la revendication 9, dans lequel chaque pixel (Pix_{1,1}, Pix_{1,2}) est relié par un chemin électrique (EP_{1,1}, EP_{1,2)} à une seconde portion métallique (MP_{1,1}, MP_{1,2}) d'un second niveau de métallisation, plus proche du substrat que le premier niveau, chaque seconde portion métallique étant séparée du substrat (12) par ladite au moins une portion isolante (18, 32), et dans lequel, pour lesdits certains pixels (Pix_{1,2}), ladite tension est appliquée, par l'intermédiaire de l'élément de couplage capacitif associé, entre la seconde portion métallique associée et le substrat.

## Claims

1. An integrated circuit (10; 30; 70; 100) comprising:
a substrate (12) of a semiconductor material,
first and second pixels (Pix_{1,1}, Pix_{1,2}), each pixel being formed of a first metal portion of a first metallization or via level, the first metal portion of each first pixel being connected to the substrate and the first metal portion of each second pixel being separated from the substrate by at least one insulating portion (18, 32), and
for each pixel (Pix_{1,1}, Pix_{1,2}), a capacitive coupling element (CE_{1,1}, CE_{1,2}) connecting the pixel to a selection element (PT_{1,1}, PT_{1,2}).

2. The circuit of claim 1, wherein each pixel (Pix_{1,1}, Pix_{1,2}) is connected, by an electric path (EP_{1,1}, EP_{1,2}), to a second metal portion (MP_{1,1}, MP_{1,2}) of a second metallization level closest to the substrate than the first level, wherein, for each of the first pixels (Pix_{1,2}), the associated second metal portion is connected to the substrate (12), and wherein, for each of the second pixels (Pix_{1,1}), the associated second metal portion is separated from the substrate by at least one insulating portion (18, 32).

3. The circuit of claim 1 or 2, wherein each pixel (Pix_{1,1} , Pix_{1,2}) has a corresponding two-state luminance and/or chrominance attribute, wherein, for each first pixel (Pix_{1,2}), the corresponding attribute is at a first state and wherein, for each second pixel (Pix_{1,1}), the corresponding attribute is at a second state.

4. The circuit of claim 2, wherein for each pixel (Pix_{1,1}, Pix_{1,2}), the associated capacitive coupling element (CE_{1,1}, CE_{1,2}) connects the associated second portion (MP_{1,1}, MP_{1,2}) to a selection element (PT_{1,1}, PT_{1,2}).

5. The circuit (30) of claim 2 or 4, wherein the capacitive coupling element (CE_{1,1}, CE_{1,2}) is a MOS transistor comprising first and second gates (42, 46), the second gate (42) being floating and being connected to the associated second portion (MP_{1,1}, MP_{1,2}), the first gate (46) being connected to the selection element (PT_{1,1}, PT_{1,2}).

6. The circuit (100) of claim 2 or 4, wherein the capacitive coupling element (CE_{1,1}, CE_{1,2}) is a MOS capacitor comprising first and second armatures (108, 104), the first armature (108) being connected to the associated second portion (MP_{1,1}, MP_{1,2}) and the second armature (104) being connected to the selection element (PT_{1,1}, PT_{1,2}).

7. The circuit of any of claims 2 and 4 to 6, wherein the second metal portion (MP_{1,1}) associated with each first pixel (Pix_{1,1}) is connected to the gate (34) of a first MOS transistor (T_{1,1}) having a gate insulator (32) which has not been altered and wherein the second metal portion (MP_{1,2}) associated with each second pixel (Pix_{1,2}) is connected to the gate of a second MOS transistor (T_{1,2}) having a gate insulator which has been altered to be conductive.

8. The circuit of any of claims 1 to 7, wherein the selection element is a first conduction terminal of a MOS power transistor (PT_{1,1}, PT_{1,2}) having a second conduction terminal connected to a power supply terminal (VPP) and having a gate adapted for receiving a selection signal.

9. A method for storing an image in an integrated circuit (10; 30; 70; 100) comprising a substrate (12) of a semiconductor material, pixels (Pix_{1,1}, Pix_{1,2}) being formed of first metal portions of a first metallization or via level, each pixel being separated from the substrate by at least one insulating portion (18, 32) , and each pixel being coupled to a selection element via a capacitive coupling element, wherein a voltage is applied between at least several pixels (Pix_{1,2}) and the substrate, via the corresponding capacitive coupling element, to alter said insulating portion and electrically connect said pixels to the substrate.

10. The method of claim 9, wherein each pixel (Pix_{1,1}, Pix_{1,2}) is connected by an electric path (EP_{1,1}, EP_{1,2}) to a second metal portion (MP_{1,1}, MP_{1,2}) of a second metallization level, closest to the substrate than the first level, each second metal portion being separated from the substrate (12) by said at least one insulating portion (18, 32), and wherein, for said at least several pixels (Pix_{1,2}), said voltage is applied, via the associated capacitive coupling element, between the second associated metal portion and the substrate.

## Patentansprüche

1. Integrierter Schaltkreis (10; 30; 70; 100) mit:
einem Substrat (12) aus einem Halbleitermaterial,
ersten und zweiten Pixeln (Pix_{1,1}, Pix_{1,2}), wobei jedes Pixel aus einem ersten Metallabschnitt mit einem ersten Metallisierungs- oder Durchgangs-Niveau gebildet ist, wobei der erste Metallabschnitt jedes ersten Pixels mit dem Substrat verbunden ist und der erste Metallabschnitt jedes zweiten Pixels von dem Substrat durch wenigstens einen Isolationsabschnitt (18, 32) getrennt ist, und
einem kapazitiven Kopplungselement (CE_{1,1}, CE_{1,2}), welches das Pixel mit einem Auswahlelement (PT_{1,1,} PT_{1,2}) verbindet, für jedes Pixel (Pix_{1,1}, Pix_{1,2}).

2. Schaltkreis nach Anspruch 1, wobei jedes Pixel (Pix_{1,1}, Pix_{1,2}) über einen elektrischen Pfad (EP_{1,1}, EP_{1,2}) mit einem zweiten Metallabschnitt (MP_{1,1}, MP_{1,2}) mit einem zweiten Metallisierungs-Niveau, das näher an dem Substrat liegt als das erste Niveau, verbunden ist, wobei für jedes der ersten Pixeln (Pix_{1,2}) der zugehörige zweite Metallabschnitt mit dem Substrat (12) verbunden ist und wobei für jedes der zweiten Pixeln (Pix_{1,1}) der zugehörige zweite Metallabschnitt von dem Substrat durch wenigstens einen Isolationsabschnitt (18, 32) getrennt ist.

3. Schaltkreis nach Anspruch 1 oder 2, wobei jedes Pixel (Pix_{1,1}, Pix_{1,2}) ein zugehöriges Luminanz- und/oder Chrominanz-Attribut mit zwei Zuständen hat, wobei für jedes erste Pixel (Pix_{1,2}) das entsprechende Attribut ein erster Zustand ist und wobei für jedes zweite Pixel (Pix_{1,1}) das entsprechende Attribut ein zweiter Zustand ist.

4. Schaltkreis nach Anspruch 2, wobei für jedes Pixel (Pix_{1,1}, Pix_{1,2}) das zugehörige kapazitive Kopplungselement (CE_{1,1}, CE_{1,2}) den zugehörigen zweiten Abschnitt (MP_{1,1}, MP_{1,2}) mit einem Auswahlelement (PT_{1,1,} PT_{1,2}) verbindet.

5. Schaltkreis (30) nach Anspruch 2 oder 4, wobei das kapazitive Kopplungselement (CE_{1,1}, CE_{1,2}) ein MOS-Transistor mit einem ersten und einem zweiten Gate (42, 46) ist, wobei das zweite Gate (42) floatend und mit den zugehörigen zweiten Abschnitt (MP_{1,1}, MP_{1,2}) verbunden ist und wobei das erste Gate (46) mit dem Auswahlelement (PT_{1,1}, PT_{1,2}) verbunden ist.

6. Schaltkreis (100) nach Anspruch 2 oder 4, wobei das kapazitive Kopplungselement (CE_{1,1}, CE_{1,2}) ein MOS-Kondensator mit einem ersten und einem zweiten Anker (108, 104) ist, wobei der erste Anker (108) mit dem zugehörigen zweiten Abschnitt (MP_{1,1}, MP_{1,2)} verbunden ist und der zweite Anker (104) mit dem Auswahlelement (PT_{1,1}, PT_{1,2)} verbunden ist.

7. Schaltkreis nach einem der Ansprüche 2 und 4 bis 6, wobei der zweite Metallabschnitt (MP_{1,1}), der jedem ersten Pixel (Pix_{1,1}) zugeordnet ist, mit dem Gate (34) des ersten MOS-Transistors (T_{1,1}) verbunden ist, dessen Gateisolator (32) unverändert ist, und wobei der zweite Metallabschnitt (MP_{1,2}), der jedem zweiten Pixel (Pix_{1,2}) zugeordnet ist, mit dem Gate eines zweiten MOS-Transistors (T_{1,2}) verbunden ist, dessen Gateisolator verändert wurde, so dass er ein Leiter ist.

8. Schaltkreis nach einem der Ansprüche 1 bis 7, wobei das Auswahlelement ein erster Leitungsanschluss eines MOS-Leistungstransistors (PT_{1,1}, PT_{1,2}) ist, der einen zweiten Leitungsanschluss hat, welcher mit einem Versorgungsanschluss mit hohem Potential (VPP) des Schaltkreises verbunden ist und dessen Gate dazu eingerichtet ist, ein Auswahlsignal zu empfangen.

9. Verfahren zum Speichern eines Bildes in einem integrierten Schaltkreis (10; 30; 70; 100) mit einem Substrat (12) aus einem Halbleitermaterial, wobei Pixel (Pix_{1,1}, Pix_{1,2}) aus ersten Metallabschnitten mit einem ersten Metallisierungs- oder Durchgangs-Niveau ausgebildet sind, wobei jedes Pixel von dem Substrat durch wenigstens einen Isolationsabschnitt (18, 32) getrennt ist und jedes Pixel mit einem Auswahlelement über ein kapazitives Kopplungselement gekoppelt ist, wobei eine Spannung zwischen wenigstens einigen Pixeln (Pix_{1,2}) und dem Substrat über ein entsprechendes kapazitives Kopplungselement angelegt wird, um den Isolationsabschnitt zu verändern und die Pixel mit dem Substrat elektrisch zu verbinden.

10. Verfahren nach Anspruch 9, wobei jedes Pixel (Pix_{1,1}, Pix_{1,2}) durch einen elektrischen Pfad (EP_{1,1}, EP_{1,2}) mit einem zweiten Metallabschnitt (MP_{1,1}, MP_{1,2}) eines zweiten Metallisierungs-Niveaus, welches näher bei dem Substrat liegt als das erste Niveau, verbunden wird, wobei jeder zweite Metallabschnitt von dem Substrat (12) durch wenigstens einen Isolationsabschnitt (18, 32) getrennt wird und wobei für wenigstens einige Pixel (Pix_{1,2}) die Spannung über das zugehörige kapazitive Kopplungselement zwischen dem zweiten zugehörigen Metallabschnitt und dem Substrat angelegt wird.
